# EUROPEAN PATENT SPECIFICATION

(11) **EP 4 390 407 B1**
(45) Date of publication and mention of the grant of the patent: **11.11.2026**
(21) Application number: 22306942.8
(22) Date of filing: 19.12.2022
(51) Int. Cl.: G01R 1/44, G01R 15/18, G01R 21/14, G01R 22/08, G01R 22/10, G01R 19/32, G01R 31/12, G01R 31/327

(54) **DEVICE FOR MEASURING TEMPERATURE GRADIENTS APPLIED TO A PRECISION ROGOWSKI SENSOR**
VORRICHTUNG ZUR MESSUNG VON TEMPERATURGRADIENTEN, DIE AUF EINEN PRÄZISIONS-ROGOWSKI-SENSOR ANGEWENDET WERDEN
DISPOSITIF DE MESURE DE GRADIENTS DE TEMPÉRATURE APPLIQUÉS À UN CAPTEUR DE PRÉCISION DE TYPE ROGOWSKI

(43) Date of publication of application: 26.06.2024
(73) Proprietor: GE Vernova Technology GmbH, 5400 Baden (CH)
(72) Inventor: JUGE, Patrice, 73100 Aix-les-Bains (FR); DUPOUY, Maxime, 73100 Aix-les-Bains (FR)
(74) Representative: Rüger Abel IP Legal Solutions GmbH

(56) References cited:
- EP-A1- 3 276 363
- WO-A1-2021/136710
- RU-U1- 203 217

## Description

### TECHNICAL FIELD AND PRIOR ART

Rogowski sensors are known to measure currents in Gas Insulated Switchgears (GIS).

They can be implemented on a printed circuit board, as disclosed in US 5 414 400 A.

However, they are subject to temperature gradients, for example between 5°C and 10 °C, which may affect the value of current measured by the sensor. In particular, their thickness is subject to important relative variations which will change the measured current value.

Figure 9 shows a Rogowski coil according to US 5 414 400 A, comprising a plate 11 of a printed circuit, for example made of epoxy resin; the coil comprises deposits of copper 3 on each face of the plate, the deposits of one face being connected to the deposits of the other face via plated through holes 5 passing through the plate.

If the temperature T1 at the bottom of the coil is less than the temperature T2 at the top, the current induced in the lower part of the coil is different from the current induced in the upper part because of the different thermal expansions. There is thus a problem of increasing the precision of the current measured by a Rogowski sensor.

WO 2021 / 136 710 A1 discloses a sensor arrangement including a Rogowski sensor having the features of the preamble of independent claim 1. The sensor arrangement comprises a first temperature sensor arranged in heat conducting connection with a capacitor of the sensor arrangement to provide a temperature measurement which is used to compensate current measurements for temperature induced variations. The sensor arrangement may comprise a second temperature sensor arranged in heat conducting connection with the Rogowski coil for measuring the temperature of the Rogowski coil when a heat conducting connection between the Rogowski coil and the capacitor cannot easily be achieved.

### PRESENTATION OF THE INVENTION

The present invention first concerns a Rogowski sensor comprising a Rogowski coil on a board, for example a printed circuit board, for a conductor of a GIS, the Rogowski sensor comprising at least 2 digital or analog temperature sensors. According to the invention, the Rogowski sensor comprising one of the following:
(i) 4 analog temperature sensors (12, 14, 16, 18), comprising 2 groups (22, 24) of 2 of said temperature sensors (12, 14, 16, 18) connected in series, said 2 groups being connected in parallel; or
(ii) n (n > 2) analog temperature sensors (12, 14, 16, 18) connected in parallel; or.
(iii) n (n > 2) digital temperature sensors (12, 14, 16, 18), connected in daisy chain.

The invention makes it possible to measure an average temperature on a current sensor of the Rogowski type, in particular of a large diameter, for example 200 mm or 450mm of external diameter or more, in order to obtain a more accurate temperature compensated current. The signals measured by a Rogowski sensor can thus be compensated based on the temperature gradients measured by the temperature sensors.

The invention is particularly useful when the current sensor is located in an environment where significant temperature gradients can exist and the accuracy constraints are high. With the present invention the accuracy class 0.1 for measuring can be achieved even in presence of temperature gradients. The accuracy required for energy pricing requires a measurement error of less than 1 A when 1000 A are circulating. This is more easily achieved in an environment where the temperature is homogeneous than in the presence of gradients. In the presence of significant temperature gradients, a distributed temperature measurement contributes to better accuracy and is one of the conditions which makes it possible to reach a more demanding accuracy class.

In an embodiment a Rogowski sensor according to the invention comprises the plurality of analog temperature sensors, which can be equivalent to an average sensor.

In another embodiment a Rogowski sensor according to the invention comprises the plurality of digital temperature sensors.

In both cases the temperature sensors can be distributed over 360°, preferably regularly, around the Rogowski coil.

A Rogowski sensor according to the invention can be provided with means, for example a calculator or a processor or a microprocessor or a computer:
- for estimating or calculating a temperature gradient between the at least two temperature sensors and/or an average temperature measured by the at least two sensors;
- and/or for estimating or calculating the temperature at the location of each temperature sensor;
- and/or for establishing a set of data or a map of the temperature distribution;
- and/or for correcting or compensating the current value measured by the Rogowski sensor on the basis of the geometrical parameters of the coil (internal diameter, external diameter, thickness of the coil measured along its axis) and possibly of the temperature measurements of at least two temperature sensors and/or of the temperature gradient between said at least two temperature sensors and/or of the average temperature measured with said at least two temperature sensors and/or of the variation of said geometrical parameters due to dilatation resulting from the temperature; such correction or compensation can be performed by computing or calculating means, for example a calculator or a processor or a microprocessor or a computer, to which the temperature data measurements are provided and programmed to implement said correction or compensation accordingly.

The invention applies to a single-phase conductor or to each phase of a system having several, for example 3, phases.

The invention also concerns a single-phase GIS, comprising a conductor and a Rogowski sensor according to the invention provided around said conductor.

The invention also concerns a 3 phase GIS, comprising 3 conductors and a Rogowski sensor according to the invention around each conductor.

In a GIS according to the invention, at least one temperature sensor can be located below, or at the bottom of, the conductor or below, or at the bottom of, each conductor, and at least one temperature sensor can be located above, or at the top of, the conductor or above, or at the top of, each conductor.

In a GIS, the invention contributes to guarantee the accuracy class of the current sensor while the GIS is under rated current load with a lot of internal thermal dissipation or in outdoor application where it is subject to sun radiation.

The load currents, i.e. the permanent currents which circulate inside a GIS conductor, can be between zero and thousands of amperes, for example 5000A. These currents circulate in a conductor whose resistance, over a given length and depending on the connections at the ends, is measured in ohms. The power dissipated is then equal to the resistance multiplied by the square of the current. For example, with a current of 4000 A and a resistance of 30 micro-ohms we obtain a power of heating (in Watts) of 0,000030 Ohms x 4000 x 4000 = 480 W. This is sufficient to significantly heat a volume of gas contained in the GIS. Mainly due to the phenomenon of convection, the heat generated at the level of the bar causes the hot gas to rise towards the top of the envelope. The Rogowski sensor, which is located around this envelope, is then forced to withstand a temperature difference of several degrees.

The invention contributes to a more accurate energy metering. The invention also concerns a current measuring system comprising a Rogowski sensor according to the invention and computing or calculating means, for example a calculator or a processor or a microprocessor or a computer, to which the temperature data measurements are provided and programmed accordingly to estimate or calculate a current in a conductor based on the measurements provided by the Rogowski sensor and possibly to correct or compensate the current as explained above.

The invention also concerns a method for measuring a current in a conductor of a GIS according to the invention, comprising measuring at least one current circulating in said conductor with the Rogowski sensor according to the invention, measuring temperatures with each of the temperature sensors of said Rogowski sensor, calculating at least one temperature gradient between said temperature sensors and/or at least one average temperature on the basis of the temperatures provided by each of said temperature sensors and compensating said measured current on the basis of said temperatures and/or on the basis of the temperature gradient between said two temperature sensors and/or of an average temperature measured with said at least two temperature sensors.

A method according to the invention can comprise establishing a set of data or a map of the temperature distribution and calculating or estimating one or more temperature gradients based on said set of data or map.

A method according to the invention can comprise a step, or a previous step, of measuring several currents in said conductor with the Rogowski sensor, measuring several temperature gradients between said at least two temperature sensors and/or several average temperatures with said at least two temperature sensors, comparing said temperature gradients and/or said average temperatures and said measured currents with at least one standard current in said conductor, and establishing a relationship between temperature gradient and/or average temperature and current.

### BRIEF DESCRIPTION OF THE DRAWINGS

- Figure 1 shows an embodiment of a Rogowski coil according to the invention;
- Figure 2 shows a bridge connection of temperature sensors of a Rogowski coil according to the invention;
- Figure 3 shows another bridge connection of temperature sensors of a Rogowski coil according to the invention;
- Figure 4 shows a parallel connection of temperature sensors of a Rogowski coil according to the invention;
- Figure 5 shows a daisy chain connection of temperature sensors of a Rogowski coil according to the invention;
- Figure 6 shows a 3 phase system, comprising 3 conductors, each associated with a Rogowski coil according to the invention;
- Figure 7 shows a measuring system associated with a Rogowski coil according to the invention;
- Figure 8 shows parameters of a Rogowski coil and different temperatures at different locations near the coil.
- Figure 9 shows a Rogowski coil according to the prior art.

### DETAILED PRESENTATION OF PARTICULAR EMBODIMENTS

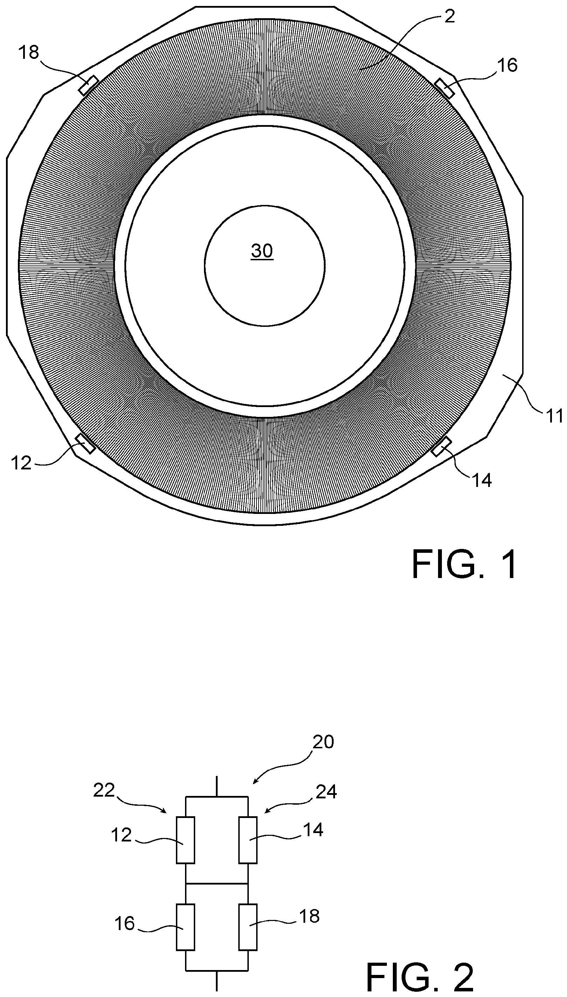

An embodiment of the present invention is shown on figure 1 and comprises a Rogowski coil 2 on a board or a plate 11, for example as disclosed in US 5 414 400 A.

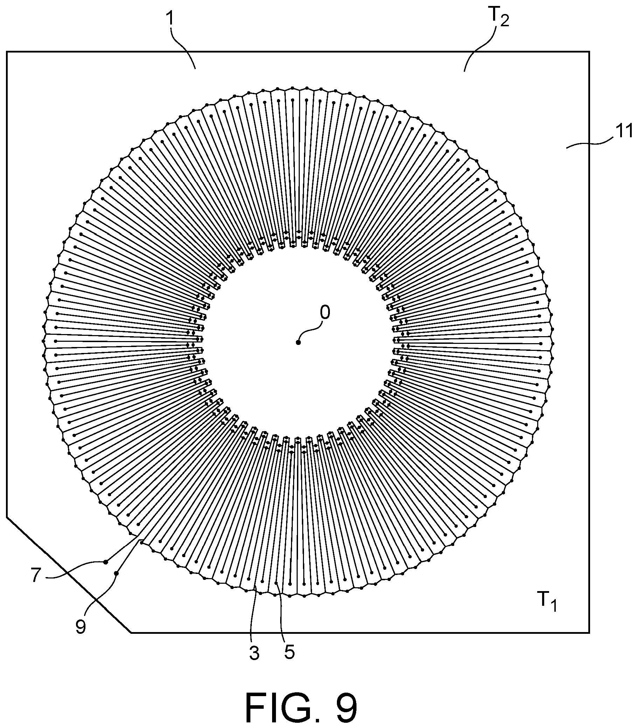

As shown on figure 9, it comprises the board or plate 11, for example of a printed circuit, for example made of epoxy resin. The coil comprises deposits of metal 3, for example copper, on each face of the plate, the deposits of one face being connected to the deposits of the other face via plated through holes 5 passing through the plate.

Reference 30 is a conductor, for example a GIS conductor, in which a current circulates. The Rogowski sensor is for measuring the current in said conductor.

This sensor is provided with several temperature sensors, at least 4 temperature sensors 12, 14, 16, 18 in this example; preferably said sensors are resistors.

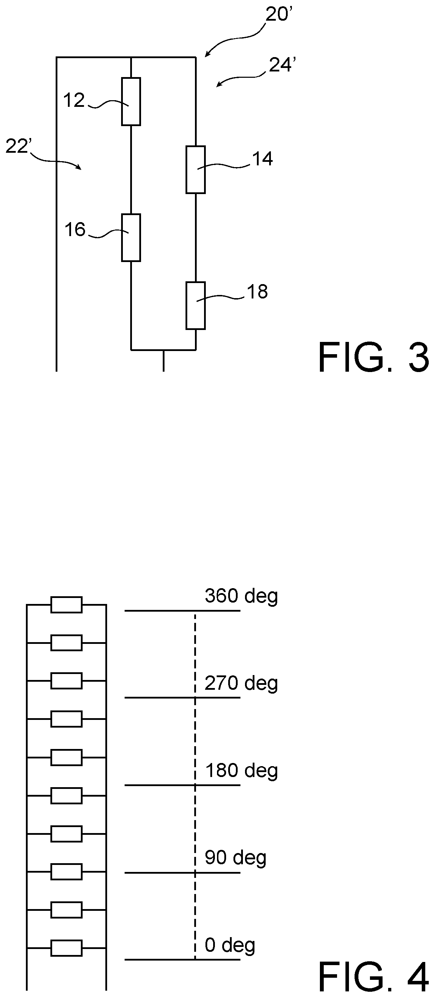

The temperature sensors may be connected as illustrated on figure 2 or on figure 3, arranged in a bridge 20, 20' comprising two legs 22 (22'), 24 (24') in parallel, each leg comprising two of said temperature sensors, actually resistors. If all resistors have the same value, this bridge allows a measure of an average temperature to be carried out at 4 different locations, with a system having an equivalent impedance value equal to that of a single resistor (for example 100 Ω). A single temperature probe, used to provide compensation for the current measurement, would indicate a temperature value at only one location, which is not the average temperature of the sensor. This introduces a compensation error and therefore a measurement error.

Alternatively, 3 sensors could be implemented instead of 4, but at least 4 sensors are preferred.

Another electric connection of the sensors is the one illustrated on figure 4, in which several sensors, for example resistors of each 1000 Ω, are connected in parallel. For example, 10 such sensors are positioned at regular intervals around the Rogowski coil of figure 1.

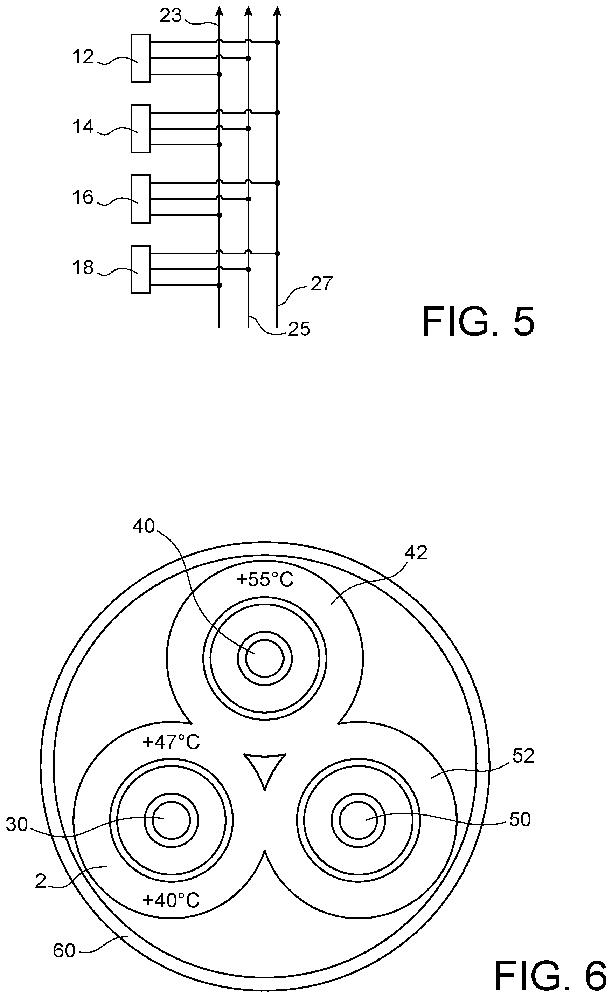

Another electric connection of the sensors is the one illustrated on figure 5, in which several sensors, 4 in this example, are connected in a "daisy chain" or "in parallel". In this case each temperature sensor has a digital address and the communication between the acquisition unit and the sensors is done digitally. It is then possible to measure temperature gradients for advanced monitoring functions. Thus, the temperature at the location of each sensor can be measured, as well as the average temperature measured by all sensors. For example, 10 such sensors can be positioned at regular intervals around the Rogowski coil. Each sensor can be connected to a ground line 23, a voltage supply line 27 (for example + 5V) and a signal line 25.

Preferably, at least one temperature sensor is located under conductor 30 and at least one above said conductor 30, so that the temperature gradient between the bottom and the top of the conductor can be estimated or measured (the hot gas rise from the bottom towards the top of the conductor, so that the temperature above the upper part of the conductor is more prone to be higher than at the bottom of the conductor). "Under" and "above" refer to the vertical direction of the location of the conductor, the hot gas rising along that vertical direction, from below the conductor or from the bottom of the conductor to above the conductor or to the top of the conductor.

In any embodiment according to the invention, the signal from each sensor can be provided to a control unit, for example a computer or a microprocessor, to sample and/or process it and to provide a temperature information.

Figure 6 represents an enclosure containing 3 conductors 30, 40, 50, for example conductors of a 3 phase system, a Rogowski coil 2, 42, 52 according to the invention being implemented around each of said conductors. There may be temperature gradients in the enclosure 60, as a result of internal dissipation from primary current in each of said conductors and/or due to sun radiation on the enclosure. For example, the bottom of the enclosure may be at a temperature of about 40°C, the middle part being for example at 47 °C and the upper part at about 55°C.

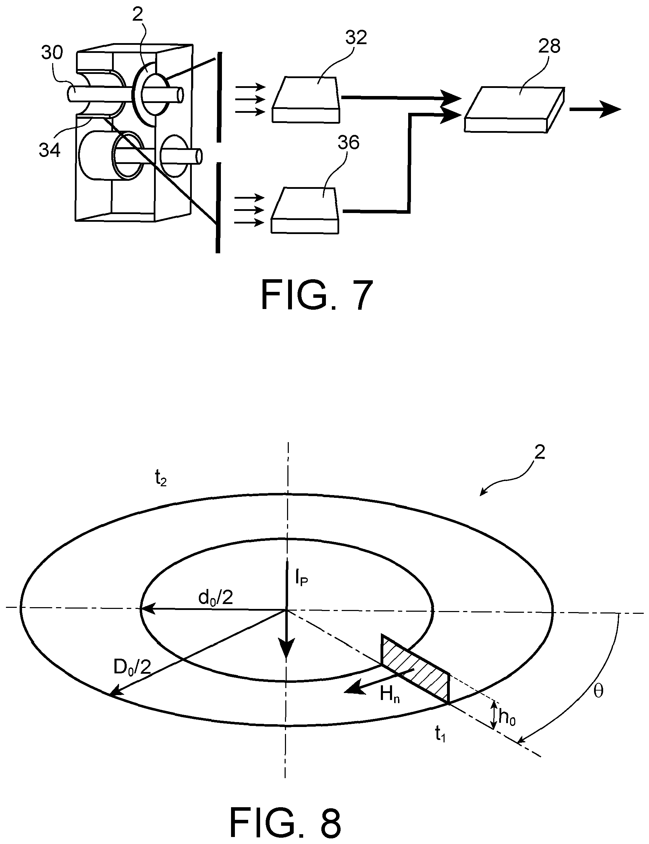

Figure 7 represents a Rogowski coil 2 according to the invention implemented around a conductor 30. The signals from the coil can be sent to a converter 32 to convert said signal into optical signals. Other signals from one or more other sensor(s), for example a capacitive sensor 34, can also be converted by a converter 36 into optical signals. The optical signals can be merged in a merging unit 28. The merging unit can comprise a microprocessor to process data and has calculation capabilities that allow it to perform current measurement compensation at least from temperature gradient information and/or from an average temperature estimated from the data provided by the several temperature sensors and/or from the temperature information provided by the several temperature sensors. The relationship for example between the temperature gradient and/or the average temperature and/or the temperature information provided by the several temperature sensors and its influence on the measured current can be measured in real time and then for example converted into a mathematical law which is recorded or accessible from a software in order to obtain an accurate current measurement.

The same measuring system may be implemented for several coils, like for example on figure 6. The current value measured by one or more Rogowski coil(s) according to the invention can be compensated on the basis of the temperature measurements of the temperature sensors and/or on the basis of an average temperature measured by said sensors and/or on the basis of a temperature gradient between at least two sensors. Alternatively, to the merging unit, a calculator or a processor or a microprocessor or a computer can be implemented, programmed to implement a method or a process according to the invention.

The influence of temperature on the current can be measured during a test, for example a previous step. Several currents can be measured for several temperature gradients and/or several average temperatures and/or several temperature data provided by at least two temperature sensors. The measurements can be compared to one or more current standard(s). This makes it possible to deduce a relationship, for example a mathematical law, between the current and the average temperature or the temperature gradient (the average temperature being preferred because easier to implement than the temperature gradient). This relationship, can then be used to correct the measured current, this correction being for example performed by a software.

The average temperature is the average temperature between different zones of the sensor.

Measuring the temperature, preferably with digital sensors, at different points or zones allows establishing a set of data or a map of the temperature distribution and identifying the temperature gradients; it also helps in detecting possible abnormal hot points.

The sensitivity of a Rogowski coil is given by:$S = N . \left({μ}_{0}/2π\right) {. h}_{0} . In \left({D}_{0}{/ d}_{0}\right) ;$

The output voltage being given by:${V}_{s} = S \left(δ{l}_{p}/δt\right)$.
Dₒ = outside diameter of the Rogowski coil (in mm);
dₒ = inside diameter of the Rogowski coil (in mm);
hₒ = thickness of the Rogowski coil;
N = number of turns of the coil;
µₒ = permittivity of vacuum;
lₚ = measured current.

But a Rogowski coil is sensitive to temperature and a compensation of the measured current lp as a function of the temperature is therefore preferred for a better precision. If the average temperature and its effect on the dilatation of the material are taken into account, the sensitivity S is given by: ${S}_{\left(t\right)} = N . \frac{{μ}_{0}}{2 Π} . {h}_{0} \left(1+{ppm}_{{h}_{0}}\left(t-{t}_{0}\right)\right) . ln \left({D}_{0}\left(1+{ppm}_{{D}_{0}}\left(t-{t}_{0}\right)\right)/{d}_{0}\left(1+{ppm}_{{d}_{0}}\left(t-{t}_{0}\right)\right)\right.$

Where:
*ppmₕₒ* = thickness variation (in mm)/C due to dilatation;
t = average temperature of the sensor;
tₒ = average temperature of reference
*ppm_{Do}* = outside diameter variation (in mm)/C due to dilatation;
*ppm_{do}* = inside diameter variation (in mm)/C due to dilatation.

Thus, if different temperatures t1 and t2 are measured on each side of the coil (figure 8), using only one of t1 and t2 to correct the measurement of current lp in the coil results in a wrong correction (the current is overcompensated or undercompensated). A temperature difference between the upper part and the lower part of the Rogowski coil can also have an effect on the sensitivity of the coil.

Therefore, in case of a temperature difference between different parts of the Rogowski coil, a single temperature sensor is not enough. In an embodiment, the invention implements measuring an average temperature to compensate the measured current lp, which results in a more precise compensation or correction. In case of digital sensors, said average temperature can be equal to the sum of the measured temperatures divided by the number of sensors.

Means for measuring a current (or a current sensor or and ammeter) and/or means for measuring a voltage (or a voltmeter) can be implemented in combination with any embodiment of a device or a sensor according to the invention, in order to measure a current in the Rogowski coil or a voltage between contacts or terminals of the Rogowski coil.

For example, the current which is measured can drift or vary approximately linearly according to the temperature with a slope of about 24 ppm/°C between -40°C and + 80°C. A slope of that order can be compensated, for example by merging unit 28 or, more generally, by means, for example, of a calculator or a processor or a microprocessor or a computer to which the temperature data measurements are provided and programmed accordingly.

## Claims

1. A Rogowski sensor comprising a Rogowski coil (2, 42, 52) on a board (11), for a conductor (30, 40, 50) of a gas insulated switchgear, GIS, said Rogowski sensor comprising at least 2 digital or analog temperature sensors (12, 14, 16, 18);
**characterized by** said Rogowski sensor comprising one of the following:
(i) 4 analog temperature sensors (12, 14, 16, 18), comprising 2 groups (22, 24) of 2 of said temperature sensors (12, 14, 16, 18) connected in series, said 2 groups being connected in parallel; or
(ii) n , where n > 2, analog temperature sensors (12, 14, 16, 18) connected in parallel; or.
(iii) n , where n > 2, digital temperature sensors (12, 14, 16, 18) connected in daisy chain.

2. A Rogowski sensor as in claim 1, wherein the temperature sensors (12, 14, 16, 18) are regularly positioned around the Rogowski coil (2, 42, 52).

3. A Rogowski sensor as in claim 1 or 2, further comprising means (28) for estimating or calculating a temperature gradient between said temperature sensors (12, 14, 16, 18) and/or an average value of the temperatures measured by said temperature sensors (12, 14, 16, 18).

4. A Rogowski sensor as in any of claims 1 to 3, further comprising means (28) for estimating or calculating the temperature at the location of each of said temperature sensors (12, 14, 16, 18).

5. A Rogowski sensor as in claim 4, further comprising means (28) for establishing a set of data or a map of the temperature distribution.

6. A Rogowski sensor as in any of claims 1 to 5, further comprising means (28) for compensating the current value measured by the Rogowski sensor on the basis of the geometrical parameters of the Rogowski coil (2, 42, 52).

7. A Rogowski sensor as in claim 6, wherein the means (28) for compensating the current value measured by the Rogowski sensor are further arranged to compensate the current value on the basis of the temperature measurements of said temperature sensors (12, 14, 16, 18) and/or of the temperature gradient between said temperature sensors (12, 14, 16, 18) and/or of the average temperature measured with said temperature sensors (12, 14, 16, 18) and/or of the variation of said geometrical parameters due to dilatation resulting from the temperature.

8. A Rogowski sensor as in any of claims 1 to 9, said Rogowski coil (2, 42, 52) having an external diameter of at least 200 mm.

9. A single phase GIS, comprising a conductor (30) and a Rogowski sensor as in any of claims 1 to 8.

10. A 3 phase GIS, comprising 3 conductors (30, 40, 50) and a Rogowski sensor as in any of claims 1 to 8 around each conductor (30, 40, 50).

11. A GIS according to any of claims 9 or 10, at least one of the temperature sensors (12, 14, 16, 18) being located below, or at the bottom of, the conductor (30) or below, or at the bottom of, each conductor (30, 40, 50), and at least one of the temperature sensors (12, 14, 16, 18) being located above, or at the top of, the conductor (30) or above, or at the top of, each conductor (30, 40, 50).

12. A method for measuring a current in a conductor (30, 40, 50) of a GIS according to any of claims 9 to 11, comprising measuring at least one current with the Rogowski sensor, measuring temperatures with each of said temperature sensors (12, 14, 16, 18), calculating at least one temperature gradient between said temperature sensors (12, 14, 16, 18) and/or at least one average temperature on the basis of the temperatures provided by each of said temperature sensors (12, 14, 16, 18) and compensating and/or correcting said measured current on the basis of said temperature gradient and/or said average temperature.

13. A method according to claim 12, comprising a step of measuring several currents with the Rogowski sensor, measuring several temperature gradients between said temperature sensors (12, 14, 16, 18) and/or several average temperatures with said temperature sensors (12, 14, 16, 18), comparing said temperature gradients and/or said average temperatures and said measured currents with at least one standard current in said conductor (30, 40, 50), and establishing a relationship between temperature gradient and/or average temperature and current.

## Patentansprüche

1. Rogowski-Sensor, der eine Rogowski-Spule (2, 42, 52) auf einer Platine (11) aufweist, für einen Leiter (30, 40, 50) einer gasisolierten Schaltanlage, GIS, wobei der Rogowski-Sensor mindestens 2 digitale oder analoge Temperatursensoren (12, 14, 16, 18) umfasst;
**dadurch gekennzeichnet, dass** der Rogowski-Sensor eines der Folgenden aufweist:
(i) 4 analoge Temperatursensoren (12, 14, 16, 18), die 2 Gruppen (22, 24) von 2 der Temperatursensoren (12, 14, 16, 18) umfassen, die in Reihe geschaltet sind, wobei die 2 Gruppen parallel geschaltet sind; oder
(ii) n, wobei n > 2, analoge Temperatursensoren (12, 14, 16, 18), die parallel geschaltet sind; oder
(iii) n, wobei n > 2, digitale Temperatursensoren (12, 14, 16, 18), die in einer Daisy Chain geschaltet sind.

2. Rogowski-Sensor nach Anspruch 1, wobei die Temperatursensoren (12, 14, 16, 18) regelmäßig um die Rogowski-Spule (2, 42, 52) herum angeordnet sind.

3. Rogowski-Sensor nach Anspruch 1 oder 2, der ferner Mittel (28) zum Schätzen oder Berechnen eines Temperaturgradienten zwischen den Temperatursensoren (12, 14, 16, 18) und/oder eines Mittelwerts der durch die Temperatursensoren (12, 14, 16, 18) gemessenen Temperaturen umfasst.

4. Rogowski-Sensor nach einem der Ansprüche 1 bis 3, der ferner Mittel (28) zum Schätzen oder Berechnen der Temperatur an der Position jedes der Temperatursensoren (12, 14, 16, 18) umfasst.

5. Rogowski-Sensor nach Anspruch 4, der ferner Mittel (28) zum Erstellen eines Datensatzes oder einer Karte der Temperaturverteilung umfasst.

6. Rogowski-Sensor nach einem der Ansprüche 1 bis 5, der ferner Mittel (28) zur Kompensation des von dem Rogowski-Sensor gemessenen Stromwerts auf der Grundlage der geometrischen Parameter der Rogowski-Spule (2, 42, 52) umfasst.

7. Rogowski-Sensor nach Anspruch 6, wobei die Mittel (28) zur Kompensation des von dem Rogowski-Sensor gemessenen Stromwerts ferner eingerichtet sind, um den Stromwert auf der Grundlage der Temperaturmessungen der Temperatursensoren (12, 14, 16, 18) und/oder des Temperaturgradienten zwischen den Temperatursensoren (12, 14, 16, 18) und/oder der mit den Temperatursensoren (12, 14, 16, 18) gemessenen Mitteltemperatur und/oder der Änderung der geometrischen Parameter aufgrund der temperaturbedingten Ausdehnung zu kompensieren.

8. Rogowski-Sensor nach einem der Ansprüche 1 bis 9, wobei die Rogowski-Spule (2, 42, 52) einen Außendurchmesser von mindestens 200 mm aufweist.

9. Einphasige GIS, die einen Leiter (30) und einen Rogowski-Sensor nach einem der Ansprüche 1 bis 8 aufweist.

10. Dreiphasige GIS, die drei Leiter (30, 40, 50) und einen Rogowski-Sensor nach einem der Ansprüche 1 bis 8 um jeden Leiter (30, 40, 50) herum aufweist.

11. GIS nach einem der Ansprüche 9 oder 10, wobei mindestens einer der Temperatursensoren (12, 14, 16, 18) unterhalb oder an der Unterseite des Leiters (30) oder unterhalb oder an der Unterseite jedes Leiters (30, 40, 50) angeordnet ist und mindestens einer der Temperatursensoren (12, 14, 16, 18) oberhalb oder an der Oberseite des Leiters (30) oder oberhalb oder an der Oberseite jedes Leiters (30, 40, 50) angeordnet ist.

12. Verfahren zum Messen eines Stroms in einem Leiter (30, 40, 50) einer GIS nach einem der Ansprüche 9 bis 11, das ein Messen mindestens eines Stroms mit dem Rogowski-Sensor, Messen von Temperaturen mit jedem der Temperatursensoren (12, 14, 16, 18), Berechnen mindestens eines Temperaturgradienten zwischen den Temperatursensoren (12, 14, 16, 18) und/oder mindestens einer Mitteltemperatur auf der Grundlage der von jedem der Temperatursensoren (12, 14, 16, 18) gelieferten Temperaturen sowie Kompensieren und/oder Korrigieren des gemessenen Stroms auf der Grundlage des Temperaturgradienten und/oder der Mitteltemperatur aufweist.

13. Verfahren nach Anspruch 12, das einen Schritt des Messens mehrerer Ströme mit dem Rogowski-Sensor, des Messens mehrerer Temperaturgradienten zwischen den Temperatursensoren (12, 14, 16, 18) und/oder mehrerer Mitteltemperaturen mit den Temperatursensoren (12, 14, 16, 18), des Vergleichens der Temperaturgradienten und/oder der Mitteltemperaturen und der gemessenen Ströme mit mindestens einem Standardstrom in dem Leiter (30, 40, 50) und des Herstellens einer Beziehung zwischen Temperaturgradient und/oder Mitteltemperatur und Strom aufweist.

## Revendications

1. Capteur de Rogowski comprenant une bobine de Rogowski (2, 42, 52) sur une carte (11), pour un conducteur (30, 40, 50) d'un appareillage à isolation gazeuse (GIS), ledit capteur de Rogowski comprenant au moins 2 capteurs de température numériques ou analogiques (12, 14, 16, 18) ;
**caractérisé par** ledit capteur de Rogowski comprenant un certain parmi :
(i) 4 capteurs de température analogiques (12, 14, 16, 18), comprenant 2 groupes (22, 24) de 2 desdits capteurs de température (12, 14, 16, 18) connectés en série, lesdits 2 groupes étant connectés en parallèle ; ou
(ii) n, où n > 2, capteurs de température analogiques (12, 14, 16, 18) connectés en parallèle ; ou.
(iii) n, où n > 2 capteurs de température numériques (12, 14, 16, 18) connectés en série.

2. Capteur de Rogowski selon la revendication 1, dans lequel les capteurs de température (12, 14, 16, 18) sont positionnés de manière régulière autour de la bobine de Rogowski (2, 42, 52).

3. Capteur de Rogowski selon la revendication 1 ou 2, comprenant en outre des moyens (28) pour estimer ou calculer un gradient de température entre lesdits capteurs de température (12, 14, 16, 18) et/ou une valeur moyenne des températures mesurées par lesdits capteurs de température (12, 14, 16, 18).

4. Capteur de Rogowski selon l'une quelconque des revendications 1 à 3, comprenant en outre des moyens (28) pour estimer ou calculer la température au niveau de l'emplacement de chacun desdits capteurs de température (12, 14, 16, 18).

5. Capteur de Rogowski selon la revendication 4, comprenant en outre des moyens (28) pour établir un ensemble de données ou une carte de la distribution de température.

6. Capteur de Rogowski selon l'une quelconque des revendications 1 à 5, comprenant en outre des moyens (28) pour compenser la valeur de courant mesurée par le capteur de Rogowski sur la base des paramètres géométriques de la bobine de Rogowski (2, 42, 52).

7. Capteur de Rogowski selon la revendication 6, dans lequel les moyens (28) pour compenser la valeur de courant mesurée par le capteur de Rogowski sont en outre agencés pour compenser la valeur de courant sur la base des mesures de température desdits capteurs de température (12, 14, 16, 18) et/ou du gradient de température entre lesdits capteurs de température (12, 14, 16, 18) et/ou de la température moyenne mesurée avec lesdits capteurs de température (12, 14, 16, 18) et/ou de la variation desdits paramètres géométriques due à la dilatation résultant de la température.

8. Capteur de Rogowski selon l'une quelconque des revendications 1 à 9, ladite bobine de Rogowski (2, 42, 52) présentant un diamètre extérieur d'au moins 200 mm.

9. GIS monophasé, comprenant un conducteur (30) et un capteur de Rogowski selon l'une quelconque des revendications 1 à 8.

10. GIS triphasé, comprenant 3 conducteurs (30, 40, 50) et un capteur de Rogowski selon l'une des revendications 1 à 8 autour de chaque conducteur (30, 40, 50).

11. GIS selon l'une quelconque des revendications 9 ou 10, au moins un des capteurs de température (12, 14, 16, 18) étant situé en dessous ou au niveau du bas du conducteur (30) ou en dessous ou au niveau du bas de chaque conducteur (30, 40, 50), et au moins un des capteurs de température (12, 14, 16, 18) est situé au-dessus ou au niveau du haut du conducteur (30) ou au-dessus ou au niveau du haut de chaque conducteur (30, 40, 50).

12. Procédé de mesure d'un courant dans un conducteur (30, 40, 50) d'un GIS selon l'une quelconque des revendications 9 à 11, comprenant une mesure d'au moins un courant avec le capteur de Rogowski, une mesure de températures avec chacun desdits capteurs de température (12, 14, 16, 18), un calcul d'au moins un gradient de température entre lesdits capteurs de température (12, 14, 16, 18) et/ou d'au moins une température moyenne sur la base des températures fournies par chacun desdits capteurs de température (12, 14, 16, 18), et une compensation et/ou une correction dudit courant mesuré sur la base dudit gradient de température et/ou de ladite température moyenne.

13. Procédé selon la revendication 12, comprenant une étape de mesure de plusieurs courants à l'aide du capteur de Rogowski, de mesure de plusieurs gradients de température entre lesdits capteurs de température (12, 14, 16, 18) et/ou de plusieurs températures moyennes avec lesdits capteurs de température (12, 14, 16, 18), de comparaison desdits gradients de température et/ou desdites températures moyennes et desdits courants mesurés avec au moins un courant standard dans ledit conducteur (30, 40, 50), et ainsi d'établissement d'une relation entre le gradient de température et/ou la température moyenne et le courant.
